# EUROPÄISCHE PATENTSCHRIFT

(11) **EP 4 145 140 B1**
(45) Veröffentlichungstag und Bekanntmachung des Hinweises auf die Patenterteilung: **13.03.2024**
(21) Anmeldenummer: 22191362.7
(22) Anmeldetag: 22.08.2022
(51) Int. Cl.: G01R 1/20, G01R 19/165, G01R 31/00

(54) **LEITERPLATTENANORDNUNG ZUR MESSUNG EINES BATTERIESTROMS EINES BATTERIEBETRIEBENEN FAHRZEUGS**
CIRCUIT BOARD ARRANGEMENT FOR MEASURING BATTERY CURRENT OF BATTERY OPERATED VEHICLE
ENSEMBLE CARTE DE CIRCUIT IMPRIMÉ PERMETTANT DE MESURER UN COURANT DE BATTERIE D'UN VÉHICULE FONCTIONNANT SUR BATTERIE

(30) Priorität: 02.09.2021 DE 102021122751
(43) Veröffentlichungstag der Anmeldung: 08.03.2023
(73) Patentinhaber: Lisa Dräxlmaier GmbH, 84137 Vilsbiburg (DE)
(72) Erfinder: Brinkmann, Andreas, 85221 Dachau (DE); Mayer, Florian, 84137 Seyboldsdorf (DE)

(56) Entgegenhaltungen:
- EP-B1- 2 732 488
- WO-A1-2017/222165
- DE-A1-102018 128 783

## Beschreibung

### Technisches Gebiet

Die vorliegende Erfindung betrifft das Gebiet der batteriebetriebenen Fahrzeuge, insbesondere der elektrisch angetriebenen Fahrzeuge. Insbesondere betrifft die Erfindung eine Leiterplattenanordnung und ein Verfahren zur Messung eines Batteriestroms eines batteriebetriebenen Fahrzeugs. Die Erfindung betrifft ferner eine Schaltbox zum Überwachen einer Batterie eines batteriebetriebenen Fahrzeugs.

### Stand der Technik

Heutige Batterie-Schaltboxen bzw. HV-Boxen zum Überwachen und Ein/Ausschalten der Batterie des Fahrzeugs verfügen über eine Vielzahl von elektrischen Leiterkarten bzw. Einzelbaugruppen, die mit jeweiligen Steckverbindern untereinander verbunden sind, um diverse Aufgaben zu erfüllen. So ist eine Leiterkarte für die Kommunikation mit dem Hauptsteuergerät zuständig, eine andere Leiterkarte ist für die Strommessung einer Stromschiene von der Batterie zu den elektrischen Komponenten des Fahrzeugs zuständig, eine weitere Leiterkarte ist für die Strommessung einer anderen Stromschiene zuständig, etc. Dies führt zu einer aufwendigen Montage der einzelnen Komponenten und Zusammenbau in der HV-Box. Durch die verschiedenen Steckverbindungen der Einzelkomponenten kann es leicht zu Montagefehlern kommen. Die Montage der Einzelkomponenten ist zudem schlecht automatisierbar und muss meist manuell durchgeführt werden.

EP 2 732 488 B1 offenbart eine Leiterplattenanordnung zur Messung eines Batteriestroms eines batteriebetriebenen Fahrzeugs mit einer Messplatine und einer Hauptplatine wobei die Messplatine mit einem Pol der Batterie verbunden werden kann und wobei die Messplatine auf der Hauptplatine befestigt ist.

DE 10 2018 128783 A1 und WO 2017/222165 A1 offenbaren jeweils eine Leiterplattenanordnung zur Messung eines Batteriestroms eines batteriebetriebenen Fahrzeugs wobei die Haupt- und Messplatine in einer einzigen Platine kombiniert sind.

### Beschreibung der Erfindung

Eine Aufgabe der Erfindung ist es daher, ein vorteilhaftes Konzept zur vereinfachten und sicheren Montage der Batterie-Schaltbox bzw. HV-Box zu schaffen, insbesondere ein Konzept zur vereinfachten Montage der HV-Box, bei dem sich der Batteriestrom präzise überwachen lässt.

Die Aufgabe wird durch die Gegenstände der unabhängigen Ansprüche gelöst. Vorteilhafte Weiterbildungen der Erfindung sind in den abhängigen Ansprüchen, der Beschreibung und den begleitenden Figuren angegeben.

Die erfinderische Lösung basiert auf der Integration mehrerer Einzelbaugruppen zu einer Backplane. Bisher getrennte Baugruppen werden zu einer zentralen Backplane mit integrierten Shunts zusammengefasst. Damit erfolgt eine Reduktion auf nur noch eine zentrale Backplane mit integrierten Shunts. Das zusätzliche Stecken der vorhandenen Shunt-Baugruppen kann somit entfallen, es wird auch kein zusätzlicher Stecker mehr dafür benötigt. Diese Lösung ist deutlich kostengünstiger herstellbar und ist zuverlässiger, da potentielle Fehlerquellen vermieden werden können.

Ein weiteres Konzept der Erfindung basiert darauf, die Lötanschlussfläche der Shunt-Baugruppen in kleine Einzelfelder bzw. Arrays aufzurastern, um damit eine präzisere Messung des Batteriestroms zu ermöglichen. Damit wird ein sogenanntes "Wandern" des Messpunktes verhindert und aufgrund der kleineren Pads kommt es zu keinem oder wesentlich geringeren Lufteinschlüssen ("Voiding") beim Herstellen der Lötverbindungen.

Gemäß einem ersten Aspekt wird die oben beschriebene Aufgabe gelöst durch eine Leiterplattenanordnung zur Messung eines Batteriestroms eines batteriebetriebenen Fahrzeugs, wobei die Leiterplattenanordnung folgendes umfasst: eine Hauptplatine mit einem oder mehreren Steckverbindern zum kabelgeführten elektrischen Verbinden der Hauptplatine mit einem Steuergerät; zumindest eine Messplatine mit einem Strommesswiderstand zur Erfassung eines Batteriestroms der Batterie des batteriebetriebenen Fahrzeugs, wobei die zumindest eine Messplatine über eine Mehrzahl von metallischen Verbindungspads auf die Hauptplatine aufgebracht ist und wobei der Strommesswiderstand über elektrische Verbindungen mit dem einen oder mehreren Steckverbindern verbunden ist, wobei die zumindest eine Messplatine mit einer Stromschiene zur Batterie mechanisch und elektrisch verbindbar ist, um einen Spannungsabfall über dem Strommesswiderstand zu erfassen und über den einen oder mehreren Steckverbinder der Hauptplatine an das Steuergerät weiterzuleiten.

Eine solche Leiterplattenanordnung, im Folgenden auch als "Backplane" bezeichnet, bietet den technischen Vorteil der Integration mehrerer Einzelbaugruppen zu einer Backplane. So wird die Hauptplatine zusammen mit den ein oder mehreren Messplatinen mittels einer gemeinsamen Backplane, d.h. der Leiterplattenanordnung, realisiert. Die bisher getrennten Baugruppen, d.h. Hauptplatine und ein oder mehrere Messplatinen, werden zu einer zentralen Backplane mit integrierten Shunts, d.h. Strommesswiderständen zusammengefasst. Damit erfolgt eine Reduktion auf nur noch eine zentrale Backplane, nämlich der besagten Leiterplattenanordnung, mit integrierten Shunts bzw. Strommesswiderständen. Das zusätzliche Stecken der vorhandenen Shunt-Baugruppen, d.h. der Messplatinen, kann somit entfallen, es wird auch kein zusätzlicher Stecker mehr dafür benötigt. Eine solche Leiterplattenanordnung ist gegenüber dem Zusammenstecken verschiedener Einzelbaugruppen deutlich kostengünstiger herstellbar und ist zuverlässiger, da potentielle Fehlerquellen bei der Montage aufgrund der bereits zusammengefügten Komponenten vermieden werden können.

Gemäß einer beispielhaften Ausführungsform der Leiterplattenanordnung ist der Strommesswiderstand als ein Messshunt ausgebildet, der ausgebildet ist, den Batteriestrom basierend auf einem Spannungsabfall an dem Messshunt und einem Nennwiderstand des Messshunts zu erfassen.

Ein solcher Messshunt bietet den Vorteil, dass über den Messshunt ein paralleler Strompfad geschaffen wird, wobei über Ermittlung des Shuntstroms, der über den Messshunt fließt, der zu messende Batteriestrom sehr genau bestimmt werden kann.

Ein Messshunt ist ein parallel geschalteter Präzisionswiderstand, der zur Messung von Wechsel- und Gleichstrom verwendet wird, indem er einen niederohmigen Pfad bildet. Ein Shunt mit niedrigem Widerstand erzeugt nur eine geringe Menge an Spannungsabfall, indem er wenig Energie in den Prozess einbringt. Mit Hilfe des Ohm'schen Gesetzes wird die Spannung im Shunt gemessen und zur Berechnung des Stromflusses in Ampere verwendet.

Gemäß einer beispielhaften Ausführungsform der Leiterplattenanordnung ist die zumindest eine Messplatine über die Mehrzahl von metallischen Verbindungspads auf die Hauptplatine gelötet, gebondet oder geschweißt.

Damit wird der Vorteil erzielt, dass eine feste Verbindung zwischen den Anschlüssen der Messplatine und den Anschlüssen der Hauptplatine erzeugt wird, so dass kein manuelles Stecken mehr notwendig ist und somit sich Fehler reduzieren lassen.

Gemäß einer beispielhaften Ausführungsform der Leiterplattenanordnung ist die zumindest eine Messplatine mit der Stromschiene der Batterie über eine Schraubverbindung verbindbar.

Damit wird der Vorteil erzielt, dass die Messplatine hohe Ströme der Batterie messen kann, wie sie bei üblichen Hochvoltbatterien zum Antrieb von elektrisch betriebenen Fahrzeugen vorkommen. Durch die Schraubverbindung wird eine feste Anbindung an die entsprechenden Kontakte der Messplatine ermöglicht, die eine sichere Stromführung gewährleistet.

Gemäß einer beispielhaften Ausführungsform der Leiterplattenanordnung sind die Mehrzahl von metallischen Verbindungspads in Form einer Rasterfläche auf der zumindest einen Messplatine angeordnet.

Damit wird der Vorteil erzielt, dass eine solche Rasterfläche sich effizienter fertigen lässt und es zu weniger Lufteinschlüssen in den Kontaktanschlussflächen kommt. Eine Mehrzahl von kleinen Kontaktflächen lässt sich besser und zuverlässiger herstellen als eine einzige große Kontaktfläche.

Gemäß einer beispielhaften Ausführungsform der Leiterplattenanordnung sind die Mehrzahl von metallischen Verbindungspads in Form eines Rasters auf der zumindest einen Messplatine angeordnet.

Durch die Anordnung in Form eines Rasters können definierte Abgriffe geschaffen werden und die Messgenauigkeit erhöht sich damit.

Gemäß einer beispielhaften Ausführungsform der Leiterplattenanordnung besteht das Raster aus zwei Rasterflächen, zwischen denen der Strommesswiderstand angebracht ist.

Dies bietet den technischen Vorteil, dass die Messung aufgrund der Geometrie der Anordnung sehr genau durchgeführt werden kann.

Gemäß einer beispielhaften Ausführungsform der Leiterplattenanordnung sind die Mehrzahl von metallischen Verbindungspads als quadratische Metallpads ausgebildet.

Dies bietet den Vorteil, dass sich effizient ein gleich großer Kontaktwiderstand auf beiden Seiten der Anschlüsse, d.h. der beiden Rasterflächen, fertigen lässt.

Gemäß einer beispielhaften Ausführungsform der Leiterplattenanordnung ist der Strommesswiderstand als ein Widerstandsmessstreifen ausgebildet ist, der zwischen den zwei Rasterflächen angeordnet ist.

Dies bietet den Vorteil, dass ein solcher Widerstand in Form eines Messstreifens sich als ein Präzisionswiderstand fertigen lässt, der eine hohe Genauigkeit bei der Messung des Batteriestroms gewährleistet. Der Widerstandsmessstreifen kann beispielsweise als ein Manganin-Messtreifen ausgebildet sein, der eine hohe Messpräzision bietet.

Gemäß einer beispielhaften Ausführungsform der Leiterplattenanordnung sind die Mehrzahl von metallischen Verbindungspads der zwei Rasterflächen symmetrisch bezüglich des Widerstandsmessstreifens auf der zumindest einen Messplatine angeordnet.

Dies bietet den Vorteil, dass eine solche symmetrische Anordnung eine hohe Messgenauigkeit der Messung des Batteriestroms ermöglicht.

Gemäß einer beispielhaften Ausführungsform der Leiterplattenanordnung weisen die beiden Rasterflächen jeweils einen Messabgriff auf, der in einer Mitte der jeweiligen Rasterfläche angebracht ist.

Ein solcher definierter Messabgriff in der Mitte bietet eine hohe Messgenauigkeit der Messung des Batteriestroms. Zudem kann ein sogenannte "differential Pair Routing" angewendet werden, um mögliche Störungen auf einer Leitung zu unterdrücken.

Gemäß einer beispielhaften Ausführungsform der Leiterplattenanordnung ist der jeweilige Messabgriff der beiden Rasterflächen als quadratisches Metallpad ausgeformt, das eine größere Fläche umfasst als Flächen der gerasterten metallischen Verbindungspads.

Dies bietet den Vorteil, dass die Messabgriffe gut kontaktierbar sind, um die an ihnen anliegenden Spannungssignale an das Steuergerät zu übertragen. In dem Steuergerät können die Spannungssignale dann über A/D-Wandler in digitale Spannungswerte gewandelt werden und anhand des vorliegenden Nennwiderstands des Widerstandsmessstreifens über das Ohm'sche Gesetz der Batteriestrom bestimmt werden.

Gemäß einer beispielhaften Ausführungsform der Leiterplattenanordnung umfasst die Leiterplattenanordnung einen Kalibrierdatenspeicher, der auf der Hauptplatine angebracht ist und ausgebildet ist, Daten zur Kalibrierung des Strommesswiderstands der zumindest einen Messplatine zu speichern.

Dies bietet den Vorteil, dass anhand dieser Daten eine Kalibrierung des Strommesswiderstands vorgenommen werden kann, so dass die gemessene Spannung über dem Strommesswiderstand präzise in einen Batteriestrom umgewandelt werden kann. Die Daten zur Kalibrierung des Strommesswiderstands können beispielsweise einen Widerstandswert des Strommesswiderstand umfassen, beispielsweise abhängig von der Umgebungstemperatur.

Gemäß einer beispielhaften Ausführungsform der Leiterplattenanordnung weist die Hauptplatine einen Hauptsteg und zwei von dem Hauptsteg abzweigende Nebenstege auf, an deren Enden jeweils eine Messplatine aufgebracht ist.

Dies bietet den Vorteil, dass sich diese Ausformung gut dazu eignet, an zwei Strommessschienen angeschlossen zu werden ohne dass die beiden Stromschienen in Kontakt zueinander geraten. Es können somit gleichzeitig zwei verschiedene Ströme hoher Stromstärke gemessen werden. Beispielsweise ein Strom der Batterie zu den Verbrauchern im Fahrzeug und ein Strom, der zurück zur Batterie fließt. Alternativ können die Ströme zweiter Batterien gemessen werden, beispielsweise der Strom der Hauptbatterie und der Strom einer redundant ausgeführten Batterie.

Gemäß einer beispielhaften Ausführungsform der Leiterplattenanordnung verlaufen die beiden Nebenstege parallel zueinander und weisen unterschiedliche Länge auf.

Dies bietet den Vorteil, dass zwei Stromschienen an einen entsprechenden Nebensteg angeschlossen werden können. Aufgrund der unterschiedlichen Länge der beiden Nebenstege können die beiden Stromschienen parallel zueinander verlaufen und sich nicht weiter gegenseitig beeinflussen.

Gemäß einem zweiten Aspekt wird die oben beschriebene Aufgabe gelöst durch eine Schaltbox zum Überwachen einer Batterie eines batteriebetriebenen Fahrzeugs, mit: einer Stromschiene, die an eine Batterie eines batteriebetriebenen Fahrzeugs anschließbar ist; und einer Leiterplattenanordnung zur Messung eines Batteriestroms des batteriebetriebenen Fahrzeugs gemäß dem oben beschriebenen ersten Aspekt, wobei die zumindest eine Messplatine mit der Stromschiene mechanisch und elektrisch verbunden ist.

Eine solche Schaltbox bietet den technischen Vorteil, dass mehrerer Einzelbaugruppen zu einer gemeinsamen Backplane integriert werden können, die in der Schaltbox platziert werden kann. Damit erfolgt eine Reduktion auf nur noch eine zentrale Backplane, nämlich der besagten Leiterplattenanordnung, mit integrierten Shunts bzw. Strommesswiderständen, die einfach in der Schaltbox montiert werden kann. Das zusätzliche Stecken der vorhandenen Shunt-Baugruppen, d.h. der Messplatinen, in der Fertigung der Schaltbox kann somit entfallen, es wird auch kein zusätzlicher Stecker mehr dafür benötigt. Eine Schaltbox lässt sich somit einfach fertigen, z.B. mittels automatischer Fertigung, und lässt sich gegenüber dem Zusammenstecken verschiedener Einzelbaugruppen deutlich kostengünstiger herstellen. Die Schaltbox ist zudem zuverlässiger, da potentielle Fehlerquellen bei der Montage aufgrund der bereits zusammengefügten Komponenten vermieden werden können.

Gemäß einem dritten Aspekt wird die oben beschriebene Aufgabe gelöst durch ein Verfahren zur Messung eines Batteriestroms eines batteriebetriebenen Fahrzeugs mit einer Leiterplattenanordnung gemäß dem oben beschriebenen ersten Aspekt, wobei das Verfahren folgendes umfasst: elektrisches Verbinden der Hauptplatine mit einem Steuergerät mittels Stecken eines Kabels von dem Steuergerät in den einen oder mehreren Steckverbinder auf der Hauptplatine; elektrisches und mechanisches Verbinden der zumindest einen Messplatine mit einer Stromschiene der Batterie; Erfassen eines Spannungsabfalls über dem Strommesswiderstand der zumindest einen Messplatine; und Weiterleiten des erfassten Spannungsabfalls über den einen oder mehreren Steckverbinder der Hauptplatine an das Steuergerät zum Bestimmen des Batteriestroms.

Ein solches Verfahren bietet die gleichen Vorteile wie die oben beschriebene Leiterplattenanordnung. D.h. die Leiterplattenanordnung ist gegenüber dem Zusammenstecken verschiedener Einzelbaugruppen deutlich kostengünstiger herstellbar und ist zuverlässiger, da potentielle Fehlerquellen bei der Montage aufgrund der bereits zusammengefügten Komponenten vermieden werden können.

Gemäß einem vierten Aspekt wird die oben beschriebene Aufgabe gelöst durch ein Computerprogramm mit einem Programmcode zum Ausführen des Verfahrens gemäß dem dritten Aspekt auf einem Computer.

Damit wird der technische Vorteil erreicht, dass das Computerprogramm einfach auf einem Steuergerät, wie z.B. auf einem Mikrocontroller ausgeführt werden kann.

### Kurze Figurenbeschreibung

Im Folgenden wird die Erfindung anhand von Ausführungsbeispielen und den Figuren näher beschrieben. Es zeigen:
- Fig. 1a: eine schematische Darstellung der Vorderseite einer Leiterplattenanordnung 100 zur Messung eines Batteriestroms eines batteriebetriebenen Fahrzeugs gemäß einem Ausführungsbeispiel;
- Fig. 1b: eine schematische Darstellung der Rückseite der Leiterplattenanordnung 100 gemäß einem Ausführungsbeispiel;
- Fig. 2: eine schematische Darstellung einer Messplatine 102a gemäß einem Ausführungsbeispiel;
- Fig. 3: eine Darstellung der Vorderseite der Messplatine 102a gemäß einem Ausführungsbeispiel;
- Fig. 4: eine drei-dimensionale Darstellung der Rückseite der Leiterplattenanordnung 100 gemäß einem Ausführungsbeispiel;
- Fig. 5: eine Darstellung eines Teils einer Schaltbox 500 zum Überwachen einer Batterie eines batteriebetriebenen Fahrzeugs, in dem sich die Leiterplattenanordnung 100 befindet; und
- Fig. 6: eine schematische Darstellung eines Verfahrens zur Messung eines Batteriestroms eines batteriebetriebenen Fahrzeugs.

Die Figuren sind lediglich schematische Darstellungen und dienen nur der Erläuterung der Erfindung. Gleiche oder gleichwirkende Elemente sind durchgängig mit den gleichen Bezugszeichen versehen.

In der folgenden ausführlichen Beschreibung wird auf die beiliegenden Zeichnungen Bezug genommen, die einen Teil hiervon bilden und in denen als Veranschaulichung spezifische Ausführungsformen gezeigt sind, in denen die Erfindung ausgeführt werden kann. Es versteht sich, dass auch andere Ausführungsformen genutzt und strukturelle oder logische Änderungen vorgenommen werden können, ohne von dem Konzept der vorliegenden Erfindung abzuweichen. Die folgende ausführliche Beschreibung ist deshalb nicht in einem beschränkenden Sinne zu verstehen. Ferner versteht es sich, dass die Merkmale der verschiedenen hierin beschriebenen Ausführungsbeispiele miteinander kombiniert werden können, sofern nicht spezifisch etwas anderes angegeben ist.

Die Aspekte und Ausführungsformen werden unter Bezugnahme auf die Zeichnungen beschrieben, wobei gleiche Bezugszeichen sich im Allgemeinen auf gleiche Elemente beziehen. In der folgenden Beschreibung werden zu Erläuterungszwecken zahlreiche spezifische Details dargelegt, um ein eingehendes Verständnis von einem oder mehreren Aspekten der Erfindung zu vermitteln. Für einen Fachmann kann es jedoch offensichtlich sein, dass ein oder mehrere Aspekte oder Ausführungsformen mit einem geringeren Grad der spezifischen Details ausgeführt werden können. In anderen Fällen werden bekannte Strukturen und Elemente in schematischer Form dargestellt, um das Beschreiben von einem oder mehreren Aspekten oder Ausführungsformen zu erleichtern. Es versteht sich, dass andere Ausführungsformen genutzt und strukturelle oder logische Änderungen vorgenommen werden können, ohne von dem Konzept der vorliegenden Erfindung abzuweichen.

In der vorliegenden Offenbarung wird eine Leiterplattenanordnung beschrieben. Eine solche Leiterplattenanordnung im Sinne der Offenbarung ist eine feste Anordnung aus verschiedenen Leiterplatten oder Platinen, die fest miteinander verbunden sind, so dass ein Stecken der Einzelkomponenten über Stecker oder Kabel entfallen kann. Die Leiterplattenanordnung lässt sich somit einfach maschinell herstellen und kann bereits im Vorfeld gefertigt werden. Die einzelnen Leiterplatten und Platinen können beispielsweise durch verschiedene Verbindungstechniken miteinander verbunden sein, z.B. mittels Löten, Schweißen, Bonden, Kleben oder anderer Techniken.

In der vorliegenden Offenbarung wird ein Messshunt bzw. ein niederohmiger Präzisionswiderstand beschrieben. Ein Messshunt ist ein parallel geschalteter Präzisionswiderstand, der zur Messung von Wechsel- und Gleichstrom verwendet wird, indem er einen niederohmigen Pfad bildet. Ein solcher Shunt mit niedrigem Widerstand, auch bekannt als ein Amperemeter-Shunt oder ein Strom-Shunt-Widerstand, erzeugt nur eine geringe Menge an Spannungsabfall, indem erwenig Energie in den Prozess einbringt. Mit Hilfe des Ohm'schen Gesetzes wird die Spannung im Shunt gemessen und zur Berechnung des Stromflusses in Ampere verwendet. Ein Widerstand mit genau bekanntem Widerstand, z.B. ein Manganin-Widerstand, ist parallel zum Amperemeter geschaltet. Der Strom wird dann so aufgeteilt, dass nur eine kleine Menge durch das Amperemeter fließt und die tatsächliche Stromstärke direkt gemessen werden kann. Für die Spezifikation eines Shunt-Widerstandes sind mehrere Parameter wichtig. Shunt-Widerstände haben einen maximalen Nennstrom. Der Widerstandswert ergibt sich aus dem Spannungsabfall bei dem maximalen Nennstrom. Weitere wichtige Parameter sind die Widerstands-Toleranz, der Temperaturkoeffizient und die Nennleistung. Die Nennleistung gibt die Menge an elektrischer Leistung an, die der Widerstand bei einer bestimmten Umgebungstemperatur ableiten kann, ohne dass die Widerstandsparameter beschädigt werden oder sich ändern. Die erzeugte Leistung kann mit dem Joules-Gesetz berechnet werden.

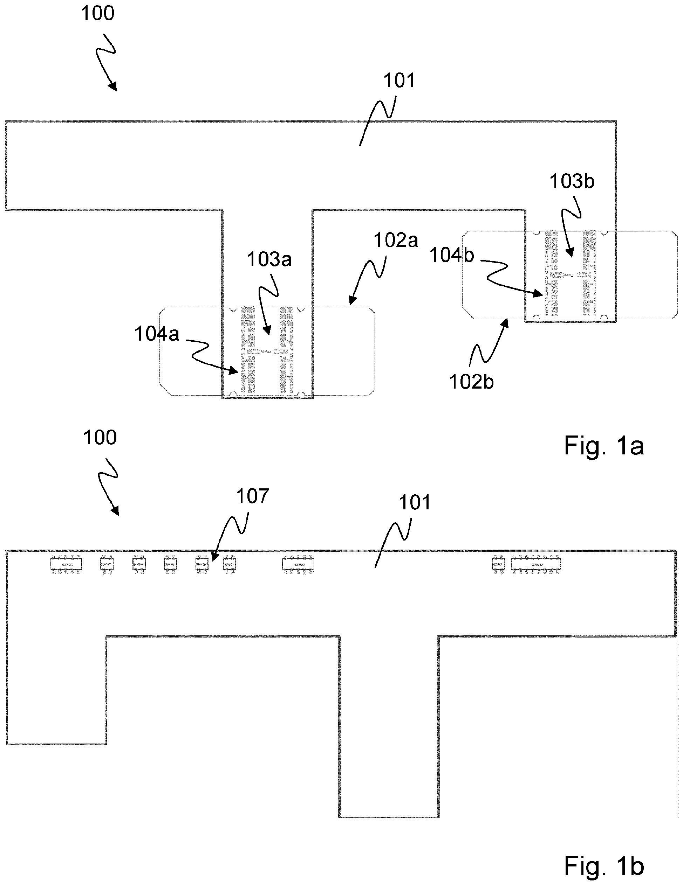

Fig. 1a zeigt eine schematische Darstellung der Vorderseite einer Leiterplattenanordnung 100 zur Messung eines Batteriestroms eines batteriebetriebenen Fahrzeugs gemäß einem Ausführungsbeispiel. Fig. 1b zeigt eine schematische Darstellung der Rückseite der Leiterplattenanordnung 100.

Die Leiterplattenanordnung 100 umfasst eine Hauptplatine 101 und eine oder mehrere Messplatinen, in dieser Ausführung zwei Messplatinen 102a, 102b.

Die Hauptplatine 101 weist einen oder mehrere Steckverbinder 107 auf zum kabelgeführten elektrischen Verbinden der Hauptplatine 101 mit einem Steuergerät, z.B. dem Hauptsteuergerät des batteriebetriebenen Fahrzeugs, auf dem die meisten Steueraufgaben ausgeführt werden.

Jede Messplatine 102a, 102b weist einen entsprechenden Strommesswiderstand 103a, 103b auf zur Erfassung eines Batteriestroms der Batterie des batteriebetriebenen Fahrzeugs. Die jeweilige Messplatine 102a, 102b ist über eine Mehrzahl von metallischen Verbindungspads 104a, 104b auf der Hauptplatine 101 aufgebracht. Der jeweilige Strommesswiderstand 103a, 103b ist über elektrische Verbindungen mit dem einen oder mehreren Steckverbindern 107 verbunden.

Über diese elektrischen Verbindungen können die Messabgriffe der jeweiligen Strommesswiderstände 103a, 103b weitergeleitet werden und über die Steckverbinder zum Steuergerät geführt werden, auf dem beispielsweise die Strommessung basierend auf der erfassten, an dem Strommesswiderstand abgefallenen Spannung bestimmt werden kann.

Die jeweilige Messplatine 102a, 102b ist mit einer Stromschiene zur Batterie mechanisch und elektrisch verbindbar, um einen Spannungsabfall über dem jeweiligen Strommesswiderstand 103a, 103b zu erfassen und über den einen oder mehreren Steckverbinder 107 der Hauptplatine 101 an das Steuergerät weiterzuleiten.

Der Strommesswiderstand 103a, 103b kann als ein Messshunt ausgebildet sein, der ausgebildet ist, den jeweiligen Batteriestrom basierend auf einem Spannungsabfall an dem Messshunt 103a, 103b und einem Nennwiderstand des Messshunts 103a, 103b zu erfassen.

Die zumindest eine Messplatine 102a, 102b kann über die Mehrzahl von metallischen Verbindungspads 104a, 104b auf die Hauptplatine 101 gelötet, gebondet oder geschweißt sein.

Beispielsweise kann die zumindest eine Messplatine 102a, 102b mit der Stromschiene 501a, 501b zur Batterie über eine Schraubverbindung verbindbar sein.

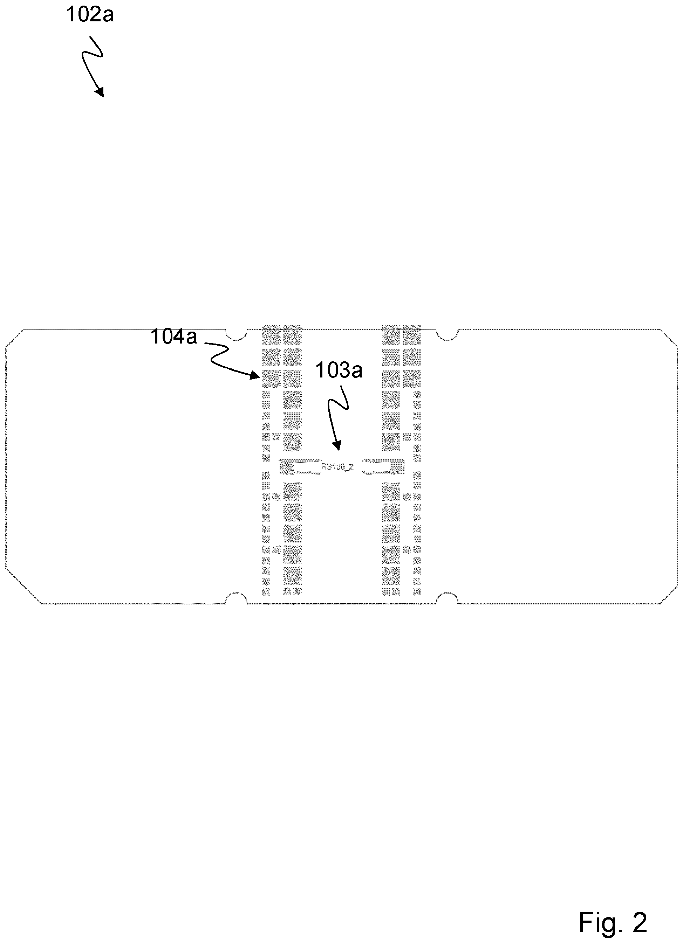

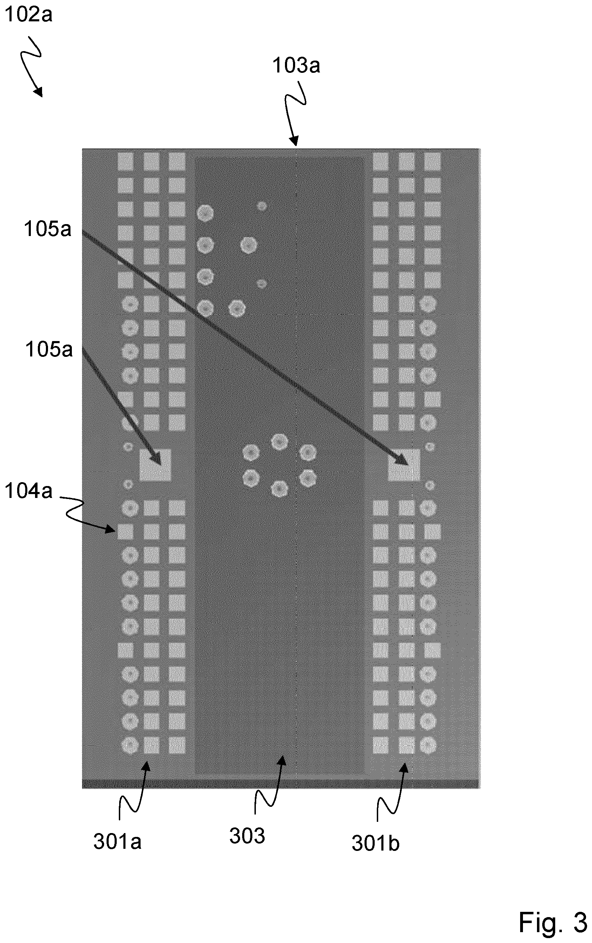

Die Mehrzahl von metallischen Verbindungspads 104a, 104b kann in Form einer Rasterfläche auf der zumindest einen Messplatine 102a, 102b angeordnet sein, wie beispielsweise näher in Figur 2 und Figur 3 dargestellt.

Die Mehrzahl von metallischen Verbindungspads 104a, 104b kann in Form eines Rasters 301a, 301b auf der zumindest einen Messplatine 102a, 102b angeordnet sein, wie beispielsweise näher in Figur 2 und Figur 3 dargestellt.

Das Raster 301a, 301b kann aus zwei Rasterflächen 301a, 301b bestehen, zwischen denen der Strommesswiderstand 303 angebracht ist, wie beispielsweise näher in Figur 3 dargestellt.

Die Mehrzahl von metallischen Verbindungspads 104a, 104b können als quadratische und/oder runde Metallpads ausgebildet sein, wie beispielsweise näher in Figur 3 dargestellt.

Der Strommesswiderstand 103a, 103b kann als ein Widerstandsmessstreifen 303 ausgebildet sein, der zwischen den zwei Rasterflächen 301a, 301b angeordnet ist.

Der Widerstandsmessstreifen kann beispielsweise aus Manganin bestehen. Manganin (CuMn12Ni) ist eine Kupfer-Nickel-Mangan-Legierung mit einer Zusammensetzung der Massenanteile von 82-84 % Kupfer, 12-15 % Mangan und 2-4 % Nickel. Es handelt sich dabei um eine Widerstandslegierung mit einer geringen Temperaturabhängigkeit des Widerstandes. Der Temperaturkoeffizient beträgt etwa α = 0,02 · 10⁻³ K⁻¹.

Der Strommesswiderstand 103a, 103b kann als ein niederohmiger Messwiderstand ausgebildet sein, z.B. mit einem Widerstand von etwa 50 µOhm. Beispielsweise können damit Ströme in der Größe von 2000 bis 3000 Ampere gemessen werden, wie sie z.B. bei Hochvoltbatterien in Elektrofahrzeugen auftreten.

Die Mehrzahl von metallischen Verbindungspads 104a, 104b der zwei Rasterflächen 301a, 301b können symmetrisch bezüglich des Widerstandsmessstreifens 303 (der Längsachse des Widerstandsmessstreifens) auf der zumindest einen Messplatine 102a, 102b angeordnet sein.

Die beiden Rasterflächen 301a, 301b können jeweils einen Messabgriff 105a aufweisen, der in einer Mitte der jeweiligen Rasterfläche 301a, 301b angebracht ist, wie näher in Figur 3 dargestellt.

Der jeweilige Messabgriff 105a der beiden Rasterflächen 301a, 301b kann als quadratisches Metallpad ausgeformt sein, das eine größere Fläche umfasst als die Flächen der gerasterten metallischen Verbindungspads 104a, 104b, wie beispielsweise näher in Figur 3 dargestellt.

Die Leiterplattenanordnung 100 kann ferner einen Kalibrierdatenspeicher umfassen, der auf der Hauptplatine 101 angebracht ist und ausgebildet ist, Daten zur Kalibrierung des Strommesswiderstands 103a, 103b der zumindest einen Messplatine 102a, 102b zu speichern. Ein solcher Kalibrierdatenspeicher kann als ein EPROM-Speicher mit geringem Speichervermögen ausgebildet sein. Der Speicher kann z.B. auf der Rückseite der Hauptplatine 101 neben den Steckverbindern 107 angeordnet sein, wie in Figur 1b dargestellt.

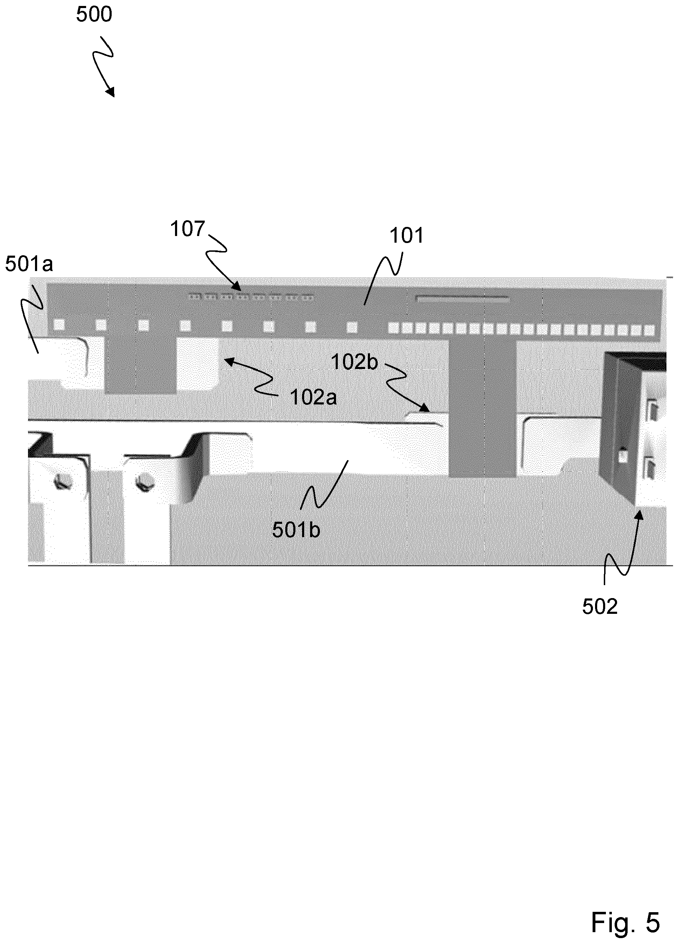

In diesem Beispiel der Figuren 1a, 1b weist die Hauptplatine 101 einen Hauptsteg und zwei von dem Hauptsteg abzweigende Nebenstege auf, an deren Enden jeweils eine Messplatine 102a, 102b aufgebracht ist. Damit können zwei parallel verlaufende Stromschienen an die beiden Messplatinen geschraubt werden, wie z.B. in Figur 5 näher dargestellt.

Die beiden Nebenstege können zueinander verlaufen und unterschiedliche Länge aufweisen. Damit kommt es zu keinen Überschneidungen der beiden Stromschienen. Sie können in einer Ebene verlaufen und doch getrennt voneinander sein. Die Leiterplattenanordnung kann somit im Wesentlichen in einer Ebene angeordnet sein, so dass sie platzsparend gefertigt werden kann.

Fig. 2 zeigt eine schematische Darstellung einer Messplatine 102a gemäß einem Ausführungsbeispiel. Die Messplatine 102a entspricht einer der oben zu Figur 1 dargestellten und beschriebenen Messplatinen 102a oder 102b.

Die Messplatine 102a weist einen Strommesswiderstand 103a auf zur Erfassung eines Batteriestroms der Batterie des batteriebetriebenen Fahrzeugs. Die Messplatine 102a ist über eine Mehrzahl von metallischen Verbindungspads 104a auf der Hauptplatine 101 aufgebracht.

Der Strommesswiderstand 103a ist über elektrische Verbindungen mit dem einen oder mehreren Steckverbindern 107 auf der Hauptplatine 101 verbunden, wie in Figur 1b dargestellt.

Über diese elektrischen Verbindungen können die zwei Messabgriffe des Strommesswiderstands 103a, die in der Mitte der Messplatine 102a angebracht sind, weitergeleitet werden und über die Steckverbinder zum Steuergerät geführt werden, auf dem beispielsweise die Strommessung basierend auf der erfassten, an dem Strommesswiderstand 103a abgefallenen Spannung bestimmt werden kann.

Die Messplatine 102a kann auf der Rückseite an eine Stromschiene zur Batterie verbunden werden, z.B. anhand einer stabilen Schraubverbindung, um einen Spannungsabfall über dem Strommesswiderstand 103a zu erfassen und über den Steckverbinder 107 der Hauptplatine 101 an das Steuergerät weiterzuleiten.

Fig. 3 zeigt eine Darstellung der Vorderseite der Messplatine 102a gemäß einem Ausführungsbeispiel.

Die Messplatine 102a kann als ein Messshunt ausgebildet sein, mit dem der Batteriestrom basierend auf einem Spannungsabfall an dem Messshunt 103a und einem Nennwiderstand des Messshunts 103a zu erfasst werden kann.

Die Messplatine 102a verfügt über eine Mehrzahl von metallischen Verbindungspads 104a, die auf die Hauptplatine 101 gelötet, gebondet oder geschweißt sein können. Damit wird eine stabile Verbindung von Messplatine 102a und Hauptplatine 101 erreicht.

Die Messplatine 102a kann mit der Stromschiene zur Batterie über eine Schraubverbindung verbunden werden, wie z.B. in Figur 5 näher dargestellt.

Die Mehrzahl der metallischen Verbindungspads 104a kann in Form einer Rasterfläche bzw. eines Rasters auf der Messplatine 102a angeordnet sein, wie in Figur 3 gut zu sehen ist.

Die Mehrzahl von metallischen Verbindungspads 104a, 104b kann in Form eines Rasters 301a, 301b auf der zumindest einen Messplatine 102a, 102b angeordnet sein, wie beispielsweise näher in Figur 2 und Figur 3 dargestellt. Bei einer solche Ausbildung als Raster kann das Ausbilden von Hohlräumen (Voids) innerhalb bzw. unterhalb der Pads stark reduziert werden. Beispielsweise lässt sich das "Voiding", d.h. das Ausbilden von Hohlräumen, reduzieren um bis zu 20% oder auch mehr.

Das Raster kann aus zwei Rasterflächen 301a, 301b bestehen, zwischen denen der Strommesswiderstand 303 angebracht ist. Die Mehrzahl der metallischen Verbindungspads 104a können als quadratische und/oder runde Metallpads ausgebildet sein.

Der Strommesswiderstand 103a kann als ein Widerstandsmessstreifen 303 ausgebildet sein, der zwischen den zwei Rasterflächen 301a, 301b angeordnet ist. Der Strommesswiderstand 103a kann als ein niederohmiger Messwiderstand ausgebildet sein, z.B. mit einem Widerstand von etwa 50 µOhm.

Die Mehrzahl von metallischen Verbindungspads 104a, 104b der zwei Rasterflächen 301a, 301b können symmetrisch bezüglich des Widerstandsmessstreifens 303, d.h. bezüglich dessen Längsachse auf der Messplatine 102a angeordnet sein.

Die beiden Rasterflächen 301a, 301b können jeweils einen Messabgriff 105a aufweisen, der in einer Mitte der jeweiligen Rasterfläche 301a, 301b angebracht ist. Damit erfolgt ein definierter Messabgriff in der Mitte. Es kann ein "differential Pair Routing" angewendet werden.

Differenzielles PCB-Routing bzw. "differential Pair Routing" ist eine Entwurfstechnik, die verwendet wird, um ein symmetrisches Übertragungssystem zu schaffen, das differenzielle (gleiche und entgegengesetzte) Signale über eine Leiterplatte übertragen kann. Jede der beiden Signalleitungen ist dabei empfängerseitig ordnungsgemäß mit ihrem eigenen Wellenwiderstand abgeschlossen.

Der jeweilige Messabgriff 105a der beiden Rasterflächen 301a, 301b kann als quadratisches Metallpad ausgeformt sein, das eine größere Fläche umfasst als die Flächen der gerasterten metallischen Verbindungspads 104a, 104b.

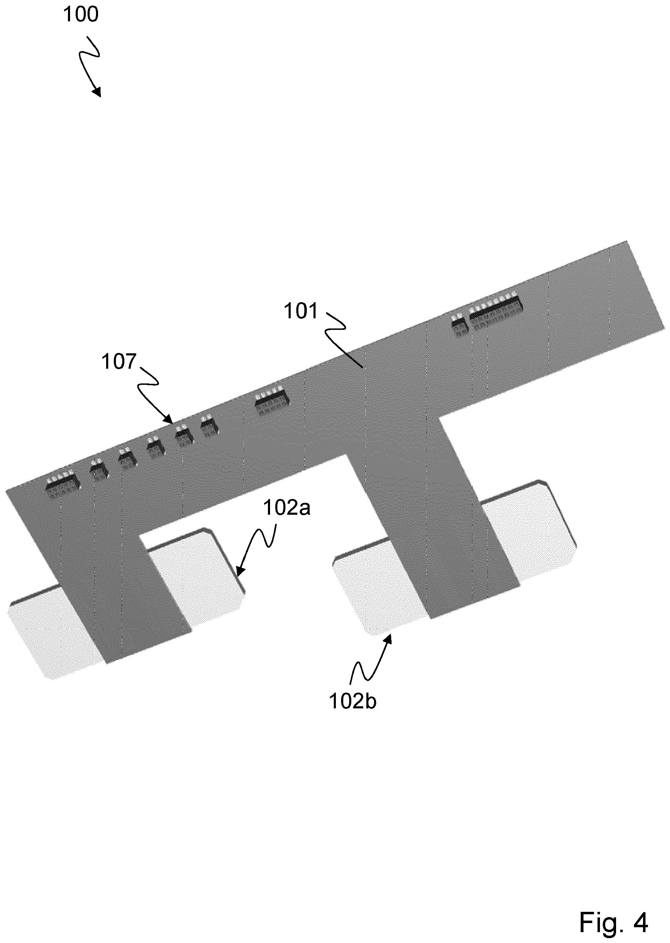

Fig. 4 zeigt eine drei-dimensionale Darstellung der Rückseite der Leiterplattenanordnung 100 gemäß einem Ausführungsbeispiel.

Die Leiterplattenanordnung 100 umfasst eine Hauptplatine 101 mit einem oder mehreren Steckverbindern 107 zum kabelgeführten elektrischen Verbinden der Hauptplatine 101 mit einem Steuergerät; zumindest eine Messplatine, in dieser Ausführung die zwei Messplatinen 102a und 102b mit einem Strommesswiderstand 103a, 103b zur Erfassung eines Batteriestroms der Batterie des batteriebetriebenen Fahrzeugs.

Die zumindest eine Messplatine 102a, 102b ist über eine Mehrzahl von metallischen Verbindungspads 104a, 104b auf die Hauptplatine 101 aufgebracht. Der Strommesswiderstand 103a, 103b ist über elektrische Verbindungen mit dem einen oder mehreren Steckverbindern 107 verbunden (nicht dargestellt in Figur 4).

Die zumindest eine Messplatine 102a, 102b ist mit einer Stromschiene zur Batterie mechanisch und elektrisch verbindbar, um einen Spannungsabfall über dem Strommesswiderstand 103a, 103b zu erfassen und über den einen oder mehreren Steckverbinder 107 der Hauptplatine 101 an das Steuergerät weiterzuleiten.

Fig. 5 zeigt eine Darstellung eines Teils einer Schaltbox 500 zum Überwachen einer Batterie eines batteriebetriebenen Fahrzeugs, in dem sich die Leiterplattenanordnung 100 befindet.

Die Schaltbox 500 ist das zentrale Steuergerät der Sensorik im Fahrzeug. Sie dient dazu, den Batteriestrom von der Batterie, z.B. der Hochvolt-Batterie im Fahrzeug, zu messen und zu überwachen. Bei Vorliegen eines Überstroms bzw. eines Kurzschlusses müssen die Stromversorgungsleitungen von der Batterie getrennt werden, um eine Schädigung des Fahrzeugs zu vermeiden.

Die Schaltbox 500 umfasst eine Stromschiene 501a, 501b, die an eine Batterie eines batteriebetriebenen Fahrzeugs anschließbar ist. Die Schaltbox 500 umfasst eine Leiterplattenanordnung 100 zur Messung eines Batteriestroms des batteriebetriebenen Fahrzeugs, wie oben zu den Figuren 1 bis 4 dargestellt. Die zumindest eine Messplatine 102a, 102b ist mit der Stromschiene mechanisch und elektrisch verbunden.

Die Leiterplattenanordnung 100 zur Messung des Batteriestroms des batteriebetriebenen Fahrzeugs umfasst eine Hauptplatine 101 mit einem oder mehreren Steckverbindern 107 zum kabelgeführten elektrischen Verbinden der Hauptplatine 101 mit einem Steuergerät, zum Beispiel dem Hauptsteuergerät des Fahrzeugs; zumindest eine Messplatine 102a, 102b mit einem Strommesswiderstand 103a, 103b zur Erfassung des Batteriestroms der Batterie, wobei die zumindest eine Messplatine 102a, 102b über eine Mehrzahl von metallischen Verbindungspads 104a, 104b auf die Hauptplatine 101 aufgebracht ist, wie oben zu den Figuren 1 bis 4 näher dargestellt, und wobei der Strommesswiderstand 103a, 103b über elektrische Verbindungen mit dem einen oder mehreren Steckverbindern 107 verbunden ist. Die zumindest eine Messplatine 102a, 102b ist mit einer Stromschiene 501a, 501b zur Batterie mechanisch und elektrisch verbunden, um einen Spannungsabfall über dem Strommesswiderstand 103a, 103b zu erfassen und über den einen oder mehreren Steckverbinder 107 der Hauptplatine 101 an das Steuergerät weiterzuleiten.

Die Schaltbox 500 umfasst in diesem Beispiel einen Schütz 502, mit dem der Stromfluss zur bzw. von der Batterie unterbrochen werden kann, falls ein Kurzschluss bzw. ein Überstromereignis festgestellt wird.

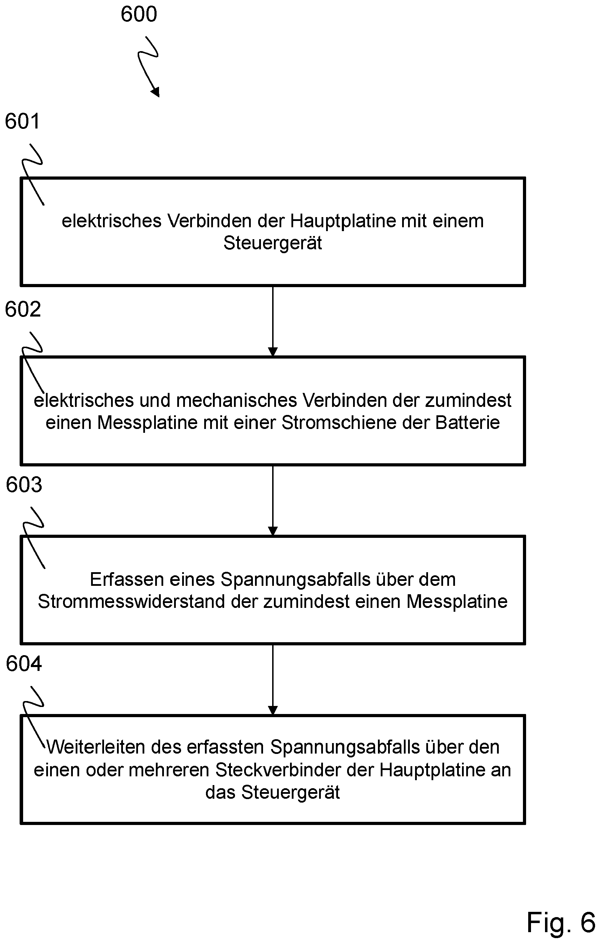

Fig. 6 zeigt eine schematische Darstellung eines Verfahrens 600 zur Messung eines Batteriestroms eines batteriebetriebenen Fahrzeugs.

Das Verfahren 600 umfasst ein elektrisches Verbinden 601 der Hauptplatine 101 mit einem Steuergerät mittels Stecken eines Kabels von dem Steuergerät in den einen oder mehreren Steckverbinder 107 auf der Hauptplatine 101, wie beispielsweise in den Figuren 1 bis 5 näher dargestellt.

Das Verfahren 600 umfasst ein elektrisches und mechanisches Verbinden 602 der zumindest einen Messplatine 102a, 102b mit einer Stromschiene der Batterie, wie beispielsweise zu den Figuren 1 bis 5 näher beschrieben.

Das Verfahren 600 umfasst ein Erfassen 603 eines Spannungsabfalls über dem Strommesswiderstand 103a, 103b der zumindest einen Messplatine 102a, 102b, wie beispielsweise zu den Figuren 1 bis 5 näher beschrieben.

Das Verfahren 600 umfasst ein Weiterleiten 604 des erfassten Spannungsabfalls über den einen oder mehreren Steckverbinder 107 der Hauptplatine 101 an das Steuergerät zum Bestimmen des Batteriestroms, wie beispielsweise zu den Figuren 1 bis 5 näher beschrieben.

### BEZUGSZEICHENLISTE

- 100: Leiterplattenanordnung
- 101: Hauptplatine
- 102a: erste Messplatine
- 102b: zweite Messplatine
- 103a: erster Strommesswiderstand
- 103b: zweiter Strommesswiderstand
- 104a, 104b: metallische Verbindungspads
- 107: Steckverbinder

- 301a: erste Rasterfläche (links)
- 301b: zweite Rasterfläche (rechts)
- 303: Widerstandsmessstreifen

- 500: Schaltbox
- 501a: erste Stromschiene
- 501b: zweite Stromschiene

- 600: Verfahren zur Messung eines Batteriestroms eines batteriebetriebenen Fahrzeugs
- 601: erster Verfahrensschritt
- 602: zweiter Verfahrensschritt
- 603: dritter Verfahrensschritt
- 604: vierter Verfahrensschritt

## Patentansprüche

1. Leiterplattenanordnung (100) zur Messung eines Batteriestroms eines batteriebetriebenen Fahrzeugs, wobei die Leiterplattenanordnung folgendes umfasst:
eine Hauptplatine (101) mit einem oder mehreren Steckverbindern (107) zum kabelgeführten elektrischen Verbinden der Hauptplatine (101) mit einem Steuergerät;
zumindest eine Messplatine (102a, 102b) mit einem Strommesswiderstand (103a, 103b) zur Erfassung eines Batteriestroms der Batterie des batteriebetriebenen Fahrzeugs, wobei die zumindest eine Messplatine (102a, 102b) über eine Mehrzahl von metallischen Verbindungspads (104a, 104b) auf die Hauptplatine (101) aufgebracht ist und wobei der Strommesswiderstand (103a, 103b) über elektrische Verbindungen mit dem einen oder mehreren Steckverbindern (107) verbunden ist,
wobei die zumindest eine Messplatine (102a, 102b) mit einer Stromschiene zur Batterie mechanisch und elektrisch verbindbar ist, um einen Spannungsabfall über dem Strommesswiderstand (103a, 103b) zu erfassen und über den einen oder mehreren Steckverbinder (107) der Hauptplatine (101) an das Steuergerät weiterzuleiten.

2. Leiterplattenanordnung (100) nach Anspruch 1,
wobei der Strommesswiderstand (103a, 103b) als ein Messshunt ausgebildet ist, der ausgebildet ist, den Batteriestrom basierend auf einem Spannungsabfall an dem Messshunt (103a, 103b) und einem Nennwiderstand des Messshunts (103a, 103b) zu erfassen.

3. Leiterplattenanordnung (100) nach Anspruch 1 oder 2,
wobei die zumindest eine Messplatine (102a, 102b) über die Mehrzahl von metallischen Verbindungspads (104a, 104b) auf die Hauptplatine (101) gelötet, gebondet oder geschweißt ist.

4. Leiterplattenanordnung (100) nach einem der vorstehenden Ansprüche,
wobei die zumindest eine Messplatine (102a, 102b) mit der Stromschiene (501a, 501b) zur Batterie über eine Schraubverbindung verbindbar ist.

5. Leiterplattenanordnung (100) nach einem der vorstehenden Ansprüche,
wobei die Mehrzahl von metallischen Verbindungspads (104a, 104b) in Form einer Rasterfläche auf der zumindest einen Messplatine (102a, 102b) angeordnet sind.

6. Leiterplattenanordnung (100) nach Anspruch 5,
wobei die Mehrzahl von metallischen Verbindungspads (104a, 104b) in Form eines Rasters (301a, 301b) auf der zumindest einen Messplatine (102a, 102b) angeordnet sind.

7. Leiterplattenanordnung (100) nach Anspruch 6,
wobei das Raster (301a, 301b) aus zwei Rasterflächen (301a, 301b) besteht, zwischen denen der Strommesswiderstand (303) angebracht ist.

8. Leiterplattenanordnung (100) nach Anspruch 7,
wobei die Mehrzahl von metallischen Verbindungspads (104a, 104b) als quadratische Metallpads ausgebildet sind.

9. Leiterplattenanordnung (100) nach Anspruch 7 oder 8,
wobei der Strommesswiderstand (103a, 103b) als ein Widerstandsmessstreifen (303) ausgebildet ist, der zwischen den zwei Rasterflächen (301a, 301b) angeordnet ist.

10. Leiterplattenanordnung (100) nach Anspruch 9,
wobei die Mehrzahl von metallischen Verbindungspads (104a, 104b) der zwei Rasterflächen (301a, 301b) symmetrisch bezüglich des Widerstandsmessstreifens (303) auf der zumindest einen Messplatine (102a, 102b) angeordnet sind.

11. Leiterplattenanordnung (100) nach einem der Ansprüche 7 bis 10,
wobei die beiden Rasterflächen (301a, 301b) jeweils einen Messabgriff (105a) aufweisen, der in einer Mitte der jeweiligen Rasterfläche (301a, 301b) angebracht ist.

12. Leiterplattenanordnung (100) nach Anspruch 11,
wobei der jeweilige Messabgriff (105a) der beiden Rasterflächen (301a, 301b) als quadratisches Metallpad ausgeformt ist, das eine größere Fläche umfasst als Flächen der gerasterten metallischen Verbindungspads (104a, 104b).

13. Leiterplattenanordnung (100) nach einem der vorstehenden Ansprüche, mit:
einem Kalibrierdatenspeicher, der auf der Hauptplatine (101) angebracht ist und ausgebildet ist, Daten zur Kalibrierung des Strommesswiderstands (103a, 103b) der zumindest einen Messplatine (102a, 102b) zu speichern.

14. Leiterplattenanordnung (100) nach einem der vorstehenden Ansprüche,
wobei die Hauptplatine (101) einen Hauptsteg und zwei von dem Hauptsteg abzweigende Nebenstege aufweist, an deren Enden jeweils eine Messplatine (102a, 102b) aufgebracht ist.

15. Leiterplattenanordnung (100) nach Anspruch 14,
wobei die beiden Nebenstege parallel zueinander verlaufen und unterschiedliche Länge aufweisen.

16. Schaltbox zum Überwachen einer Batterie eines batteriebetriebenen Fahrzeugs, mit:
einer Stromschiene, die an eine Batterie eines batteriebetriebenen Fahrzeugs anschließbar ist; und
einer Leiterplattenanordnung (100) zur Messung eines Batteriestroms des batteriebetriebenen Fahrzeugs gemäß einem der Ansprüche 1 bis 14,
wobei die zumindest eine Messplatine (102a, 102b) mit der Stromschiene mechanisch und elektrisch verbunden ist.

17. Verfahren zur Messung eines Batteriestroms eines batteriebetriebenen Fahrzeugs mit einer Leiterplattenanordnung gemäß einem der Ansprüche 1 bis 14, wobei das Verfahren folgendes umfasst:
elektrisches Verbinden der Hauptplatine mit einem Steuergerät mittels Stecken eines Kabels von dem Steuergerät in den einen oder mehreren Steckverbinder auf der Hauptplatine;
elektrisches und mechanisches Verbinden der zumindest einen Messplatine (102a, 102b) mit einer Stromschiene der Batterie;
Erfassen eines Spannungsabfalls über dem Strommesswiderstand (103a, 103b) der zumindest einen Messplatine (102a, 102b); und
Weiterleiten des erfassten Spannungsabfalls über den einen oder mehreren Steckverbinder (107) der Hauptplatine (101) an das Steuergerät zum Bestimmen des Batteriestroms.

## Claims

1. PCB arrangement (100) for measuring a battery current of a battery-powered vehicle, whereas the PCB arrangement comprises the following:
a main board (101) with one or more plug connectors (107) for a wired electrical connection of the main board (101) to a control device;
at least one measuring circuit board (102a, 102b) with a current sensing resistor (103a, 103b) for detecting a battery current of the battery of the battery-powered vehicle, wherein the at least one measuring circuit board (102a, 102b) is applied to the main board (101) via a plurality of metal connecting pads (104a, 104b) and wherein the current sensing resistor (103a, 103b) is connected electrically to the one or more plug connectors (107),
wherein the at least one measuring circuit board (102a, 102b) can be mechanically and electrically connected to a busbar to the battery in order to detect a voltage drop across the current sensing resistor (103a, 103b) and pass it on to the control unit via the one or more plug connectors (107) of the main circuit board (101).

2. PCB arrangement (100) according to claim 1,
wherein the current sensing resistor (103a, 103b) is designed as a measuring shunt which is designed to measure the battery current based on a voltage drop at the measuring shunt (103a, 103b) and a nominal resistance of the measuring shunt (103a, 103b).

3. PCB arrangement (100) according to claim 1 or 2,
wherein the at least one measuring circuit board (102a, 102b) is soldered, bonded or welded to the main circuit board (101) by means of the plurality of metal connecting pads (104a, 104b).

4. PCB arrangement (100) according to any one of the preceding claims,
wherein the at least one measuring circuit board (102a, 102b) can be connected with the busbar (501a, 501b) to the battery via a screw connection.

5. PCB arrangement (100) according to any one of the preceding claims,
wherein the plurality of metal connecting pads (104a, 104b) are arranged in the form of a grid surface on the at least one measuring circuit board (102a, 102b).

6. PCB arrangement (100) according to claim 5,
wherein the plurality of metal connecting pads (104a, 104b) are arranged in the form of a grid (301a, 301b) on the at least one measuring circuit board (102a, 102b).

7. PCB arrangement (100) according to claim 6,
wherein the grid (301a, 301b) consists of two grid surfaces (301a, 301b), between which the current sensing resistor (303) is mounted.

8. PCB arrangement (100) according to claim 7,
wherein the plurality of metal connecting pads (104a, 104b) are formed as square metal pads.

9. PCB arrangement (100) according to claim 7 or 8,
wherein the current sensing resistor (103a, 103b) is designed as a resistance measuring strip (303), which is arranged between the two grid surfaces (301a, 301b).

10. PCB arrangement (100) according to claim 9,
wherein the plurality of metal connecting pads (104a, 104b) of the two grid surfaces (301a, 301b) are arranged symmetrically with respect to the resistance measuring strip (303) on the at least one measuring circuit board (102a, 102b).

11. PCB arrangement (100) according to any one of claims 7 to 10,
wherein the two grid surfaces (301a, 301b) each have a string part (105a) which is mounted in a center of the respective grid surface (301a, 301b).

12. PCB arrangement (100) according to claim 11,
wherein the respective string part (105a) of the two grid surfaces (301a, 301b) is formed as a square metal pad which comprises a larger surface area than the surface areas of the screened metal connecting pads (104a, 104b).

13. PCB arrangement (100) according to any one of the preceding claims, comprising:
a calibration data memory which is mounted on the main board (101) and is designed to store data for calibrating the current sensing resistor (103a, 103b) of the at least one measuring circuit board (102a, 102b).

14. PCB arrangement (100) according to any one of the preceding claims,
wherein the main board (101) has a main web and two secondary webs branching off from the main web, to each end of which a measuring circuit board (102a, 102b) is attached.

15. PCB arrangement (100) according to claim 14,
whereby the two secondary webs run parallel to each other and have different lengths.

16. Switch box for monitoring a battery of a battery-powered vehicle, with:
a busbar that can be connected to a battery of a battery-powered vehicle; and
a PCB arrangement (100) for measuring a battery current of the battery-powered vehicle according to any one of claims 1 to 14,
wherein the at least one measuring circuit board (102a, 102b) is mechanically and electrically connected to the busbar.

17. Method of measuring a battery current of a battery-powered vehicle having a PCB arrangement according to any one of claims 1 to 14, wherein the method comprises:
electrical connection of the main board to a control unit by plugging a cable from the control unit into one or more connectors on the main board;
electrical and mechanical connection of the at least one measuring circuit board (102a, 102b) to a busbar of the battery;
detecting a voltage drop by means of the current sensing resistor (103a, 103b) of the at least one measuring circuit board (102a, 102b); and
forwarding the detected voltage drop via the one or more plug connectors (107) of the main board (101) to the control unit for determining the battery current.

## Revendications

1. Ensemble de cartes de circuit imprimé (100) pour mesurer un courant de batterie d'un véhicule alimenté par batterie, l'ensemble de cartes de circuit imprimé comprenant :
une platine principale (101) avec un ou plusieurs connecteurs (107) pour la connexion électrique guidée par câble de la platine principale (101) avec un appareil de commande ;
au moins une carte de mesure (102a, 102b) avec une résistance de mesure de courant (103a, 103b) pour détecter un courant de batterie de la batterie du véhicule alimenté par batterie, la au moins une carte de mesure (102a, 102b) étant appliquée sur la carte principale (101) par l'intermédiaire d'une pluralité de pastilles de connexion métalliques (104a, 104b) et la résistance de mesure de courant (103a, 103b) étant connectée par l'intermédiaire de connexions électriques à l'un ou plusieurs connecteurs (107),
dans lequel la au moins une carte de mesure (102a, 102b) peut être reliée mécaniquement et électriquement à un rail d'alimentation vers la batterie pour détecter une chute de tension aux bornes de la résistance de mesure de courant (103a, 103b) et la transmettre à l'appareil de commande par l'intermédiaire du ou des connecteurs (107) de la carte principale (101).

2. Ensemble de cartes de circuits imprimés (100) selon la revendication 1,
dans lequel la résistance de mesure de courant (103a, 103b) est formée comme un shunt de mesure adapté pour détecter le courant de batterie sur la base d'une chute de tension aux bornes du shunt de mesure (103a, 103b) et d'une résistance nominale du shunt de mesure (103a, 103b).

3. Ensemble de cartes de circuits imprimés (100) selon la revendication 1 ou 2,
dans lequel la au moins une carte de mesure (102a, 102b) est brasée, liée ou soudée sur la carte principale (101) par l'intermédiaire de la pluralité de plots de connexion métalliques (104a, 104b).

4. Ensemble de cartes de circuits imprimés (100) selon l'une quelconque des revendications précédentes,
l'au moins une platine de mesure (102a, 102b) pouvant être reliée à la barre conductrice (501a, 501b) vers la batterie par un assemblage vissé.

5. Ensemble de cartes de circuits imprimés (100) selon l'une quelconque des revendications précédentes,
dans lequel la pluralité de pastilles de connexion métalliques (104a, 104b) sont disposées sous la forme d'une surface de trame sur la au moins une carte de mesure (102a, 102b).

6. Ensemble de cartes de circuits imprimés (100) selon la revendication 5,
dans lequel la pluralité de pastilles de connexion métalliques (104a, 104b) sont disposées sous la forme d'une grille (301a, 301b) sur la au moins une carte de mesure (102a, 102b).

7. Ensemble de cartes de circuits imprimés (100) selon la revendication 6,
la grille (301a, 301b) étant constituée de deux surfaces de grille (301a, 301b) entre lesquelles la résistance de mesure de courant (303) est montée.

8. Ensemble de cartes de circuits imprimés (100) selon la revendication 7,
dans lequel la pluralité de pastilles de connexion métalliques (104a, 104b) sont formées comme des pastilles métalliques carrées.

9. Ensemble de cartes de circuits imprimés (100) selon la revendication 7 ou 8,
dans lequel la résistance de mesure de courant (103a, 103b) est conçue comme une bande de mesure de résistance (303) qui est disposée entre les deux surfaces de grille (301a, 301b).

10. Ensemble de cartes de circuits imprimés (100) selon la revendication 9,
dans lequel la pluralité de pastilles de connexion métalliques (104a, 104b) des deux surfaces de grille (301a, 301b) sont disposées symétriquement par rapport à la bande de mesure de résistance (303) sur la au moins une carte de mesure (102a, 102b).

11. Ensemble de cartes de circuits imprimés (100) selon l'une quelconque des revendications 7 à 10,
dans lequel les deux surfaces de trame (301a, 301b) comprennent chacune une prise de mesure (105a) montée au centre de la surface de trame respective (301a, 301b).

12. Ensemble de cartes de circuits imprimés (100) selon la revendication 11,
dans lequel la prise de mesure respective (105a) des deux surfaces tramées (301a, 301b) est formée comme une pastille métallique carrée qui comprend une surface plus grande que des surfaces des pastilles de connexion métalliques tramées (104a, 104b).

13. Ensemble de cartes de circuits imprimés (100) selon l'une quelconque des revendications précédentes, comprenant :
une mémoire de données d'étalonnage qui est montée sur la carte principale (101) et qui est conçue pour stocker des données pour l'étalonnage de la résistance de mesure de courant (103a, 103b) de la au moins une carte de mesure (102a, 102b).

14. Ensemble de cartes de circuits imprimés (100) selon l'une quelconque des revendications précédentes,
la platine principale (101) présentant une barrette principale et deux barrettes secondaires se ramifiant à partir de la barrette principale, à chacune des extrémités desquelles est appliquée une platine de mesure (102a, 102b).

15. Ensemble de cartes de circuits imprimés (100) selon la revendication 14,
les deux barrettes secondaires étant parallèles entre elles et de longueur différente.

16. Boîtier de commutation pour la surveillance d'une batterie d'un véhicule alimenté par batterie, avec :
une barre omnibus pouvant être connectée à une batterie d'un véhicule alimenté par batterie ; et
un ensemble de cartes de circuits imprimés (100) pour mesurer un courant de batterie du véhicule alimenté par batterie selon l'une quelconque des revendications 1 à 14,
dans lequel la au moins une carte de mesure (102a, 102b) est reliée mécaniquement et électriquement à la barre conductrice.

17. Procédé de mesure d'un courant de batterie d'un véhicule alimenté par batterie avec un ensemble de carte de circuit imprimé selon l'une quelconque des revendications 1 à 14, le procédé comprenant :
connexion électrique de la carte principale à un appareil de commande par enfichage d'un câble de l'appareil de commande dans le ou les connecteurs sur la carte principale ;
connexion électrique et mécanique de la au moins une carte de mesure (102a, 102b) à une barre conductrice de la batterie ;
détecter une chute de tension aux bornes de la résistance de mesure de courant (103a, 103b) de ladite au moins une carte de mesure (102a, 102b) ; et
transmettre la chute de tension détectée, par l'intermédiaire du ou des connecteurs (107) de la carte principale (101), à l'unité de commande pour déterminer le courant de la batterie.
